# EUROPEAN PATENT APPLICATION

(11) **EP 4 325 582 A1**
(43) Date of publication of application: **21.02.2024**
(21) Application number: 22212514.8
(22) Date of filing: 09.12.2022
(51) Int. Cl.: H01L 29/778, H01L 29/41, H01L 29/10, H01L 29/423, H01L 29/207, H01L 29/20

(54) **GALLIUM NITRIDE TRANSISTOR FOR REDUCING INPUT CAPACITANCE OF MULTILAYER FIELD PLATE**

(30) Priority: 16.08.2022 CN 202210978211
(71) Applicant: Hefei Aichuang Microelectronics Technology Co., Ltd, Hefei City, Anhui 231200 (CN)
(72) Inventor: PAN, Jun, Hefei City, 231200 (CN); XIAO, Hailin, Hefei City, 231200 (CN); ZHANG, Shengyuan, Hefei City, 231200 (CN)
(74) Representative: Wächter, Jochen

(57) **Abstract**

A gallium nitride (GaN) transistor for reducing input capacitance of a multilayer field plate is provided, including a GaN substrate (10), a source region (20), a drain region (30), and a gate region (40). The gate region is formed in the GaN substrate and includes a gate stack (50) in contact with a portion of the GaN substrate, where the gate region is arranged between the source region and the drain region, and a gate field plate (511) extending towards the drain region is provided at one side of a gate metal (51) of the gate stack; a first source field plate (211) extending towards the drain region and across the gate field plate is provided at one side of a first source ohmic metal (21), and the first source field plate has a hollow structure region (60).

## Description

### TECHNICAL FIELD

The present disclosure relates to the technical field of semiconductor devices, and in particular to gallium nitride high electron mobility transistor (HEMT) semiconductor devices for reducing input capacitance of a multilayer field plate.

### BACKGROUND

As representative of a third generation semiconductor material after a first generation semiconductor silicon (Si) and a second generation semiconductor gallium arsenide (GaAs), gallium nitride (GaN) has many excellent material properties, such as wide band gap, high temperature resistance, high electron concentration, high electron mobility, high thermal conductivity, and so on. Therefore, GaN-based high electron mobility transistors (HEMTs) have excellent performance in microwave communication and power electronic conversion, and are especially suitable for manufacturing high-power electronic devices.

GaN power device is a kind of planar channel field effect transistor. When a voltage applied between a gate and a drain increases, a high electric field spike will be formed at an edge of the gate near the drain, which may easily cause leakage current of the device to increase, thereby often leading to device failure and affecting device reliability. In order to solve the problem that the electric field is too concentrated, in the prior art, the electric field is dispersed by gradually stacking multiple gatings, source field plates and multiple layers of field plates. This is mainly because a peak electric field is generated at each edge of the field plate, and the electric field peak at the edge of the gate is weakened by the voltage dividing effect, so that a high electric field spike is dispersed into several small electric field spikes, thereby improving the breakdown voltage and increasing lifetime and reliability of the device.

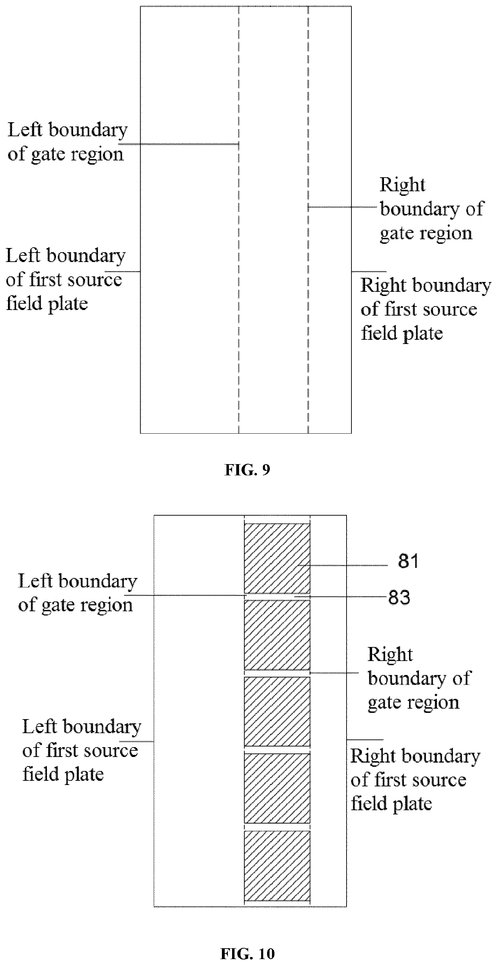

However, the above multilayer gate and source field plate structure not only improves performance of the device, but also increases input capacitance. As shown in FIG.9, since a source field plate and a gate field plate are introduced, and the source field plate crosses over a gate metal, there is a dielectric layer 90 between the source field plate and the gate metal. The source field plate, the insulating dielectric and the gate metal constitute a parallel plate capacitor model, and the parasitic capacitance generated thereby can be calculated by a formula C=Q/U=εᵣε₀S/d, where Q represents an amount of charge carried by the plate, U represents a voltage difference across two plates, and εᵣ represents a relative dielectric constant of the insulating dielectric, ε₀ represents a vacuum dielectric constant, S represents an equivalent facing area of the two plates, d represents an equivalent distance between the two plates. It can be seen from C=Q/U that when the gate-source voltage U is specified, the larger the C is, the larger the Q is, which means a longer charging time, and in turn a slower switching speed, and thus the more energy will be lost in switching.

The capacitance of the transistor is an important parameter characterizing the loss of energy in the device during a transition from an on-state to an off-state of the device. However, in the prior art, the parasitic capacitance reduces the amount of charge, and the charging time becomes shorter, that is the time of charge provision is shorted, thereby affecting the switching and frequency characteristics of the device.

### SUMMARY

The present disclosure provides a gallium nitride(GaN) transistor for reducing input capacitance of a multilayer field plate, which has a hollow structure of gate-source multilayer field plate to reduce the input capacitance of the device and improve the switching and frequency characteristics of the device.

To solve the above technical problems, the present disclosure adopts the following technical solution.

A gallium nitride (GaN) transistor for reducing input capacitance of a multilayer field board, comprising:
a GaN substrate;
a source region formed in the GaN substrate and including a first source ohmic metal in contact with a portion of the GaN substrate;
a drain region formed in the GaN substrate and separated from the source region; and
a gate region formed in the GaN substrate and including a gate stack in contact with a portion of the GaN substrate, wherein the gate region is arranged between the source region and the drain region, and a gate field plate extending towards the drain region is provided at one side of a gate metal of the gate stack;
wherein a first source field plate extending towards the drain region and across the gate field plate is provided at one side of the first source ohmic metal, and the first source field plate has a hollow structure region.

Further, a second source metal is further formed on the first source ohmic metal, a second source field plate extending towards the drain region and across the first source field plate is provided at one side of the second source metal, the second source field plate has a hollow structure region, and the hollow structure region of the second source field plate overlaps at least in part with the hollow structure region of the first source field plate in a longitudinal direction.

Preferably, the hollow structure region comprises a plurality of longitudinal through-holes filled in the hollow structure region and perpendicular to surfaces of the field plates.

Preferably, the longitudinal through-holes of the second source field plate and the longitudinal through-holes of the first source field plate are arranged concentrically from top to bottom, and the aperture of the longitudinal through-holes of the second source field plate is greater than or equal to the aperture of the longitudinal through-holes of the first source field plate.

Preferably, the plurality of longitudinal through-holes are any one of rectangular holes, circular holes, pentagonal holes, and triangular holes.

It can be seen from the above technical solution that, in the present disclosure, the field plate structure is designed to be hollow, such that the facing area between the gate field plate and the source field plate is reduced, thereby reducing parasitic capacitance between the gate and source, that is, the amount of charge is reduced, the charging time becomes shorter, and the faster the charge is provided, the faster the voltage of the device changes. Therefore, reducing input capacitance of the gate and source can improve the conversion efficiency and frequency characteristics of the device.

### BRIEF DESCRIPTION OF THE DRAWINGS

FIG. 1 is a longitudinal sectional view of an embodiment 1 of a gallium nitride (GaN) transistor according to the present disclosure;
FIG. 2 is a longitudinal sectional view of an embodiment 2 of the GaN transistor according to the present disclosure;
FIG. 3 is a longitudinal sectional view of an embodiment 3 of the GaN transistor according to the present disclosure;
FIG. 4 is a longitudinal sectional view of an embodiment 4 of the GaN transistor according to the present disclosure;
FIG. 5 is a longitudinal sectional view of an embodiment 5 of the GaN transistor according to the present disclosure;
FIG. 6 is a longitudinal sectional view of an embodiment 6 of the GaN transistor according to the present disclosure;
FIG. 7 is a longitudinal sectional view of an embodiment 7 of theGaN transistor according to the present disclosure;
FIG. 8 is a longitudinal sectional view of an embodiment 8 of the GaN transistor according to the present disclosure;
FIG. 9 is a top view of regions of a first source field plate and a gate field plate in the prior art;
FIG. 10 is a top view of longitudinal through-holes in the first source field plate in which the longitudinal through-holes are rectangular holes in embodiment 1;
FIG. 11 is a top view of longitudinal through-holes in the first source field plate in which the longitudinal through-holes are circular holes in embodiment 1;
FIG. 12 is a top view of longitudinal through-holes in the first source field plate in which the longitudinal through-holes are pentagonal holes in embodiment 1;
FIG. 13 is a top view of longitudinal through-holes in the first source field plate in which the longitudinal through-holes are triangular holes in embodiment 1.

### DETAILED DESCRIPTION OF THE EMBODIMENTS

A preferred embodiment of the present disclosure is described in detail below in conjunction with the accompanying drawings.

A gallium nitride (GaN) transistor according to the present disclosure can be used to reduce input capacitance among a multiple field plate layers, which includes a GaN substrate 10, and a source region 20, a drain region 30 and a gate region 40 formed in or on the GaN substrate. The gate region is arranged between the source region and the drain region, the drain region is separated from the source region, and a dielectric layer 90 is filled among the source region, the drain region and the gate region.

The GaN substrate 10 includes a substrate and a multilayer functional structure formed on the substrate. The multilayer functional structure may be provided as desired and may include, but not limited to, a substrate, a nucleation layer, a buffer layer, a first GaN layer, a second GaN layer and an AlGaN barrier layer stacked in sequence. The multilayer functional structure may also include a nucleation layer, a buffer layer, a first insertion layer, a first GaN layer, a second insertion layer, a second GaN layer, and an AlGaN barrier layer stacked in sequence. The nucleation layer is connected to the substrate, and the substrate may be sapphire, silicon, or GaN.

In the present disclosure, the structure of the source region 20, the drain region 30 and the gate region 40 is described in eight embodiments.

### Embodiment 1

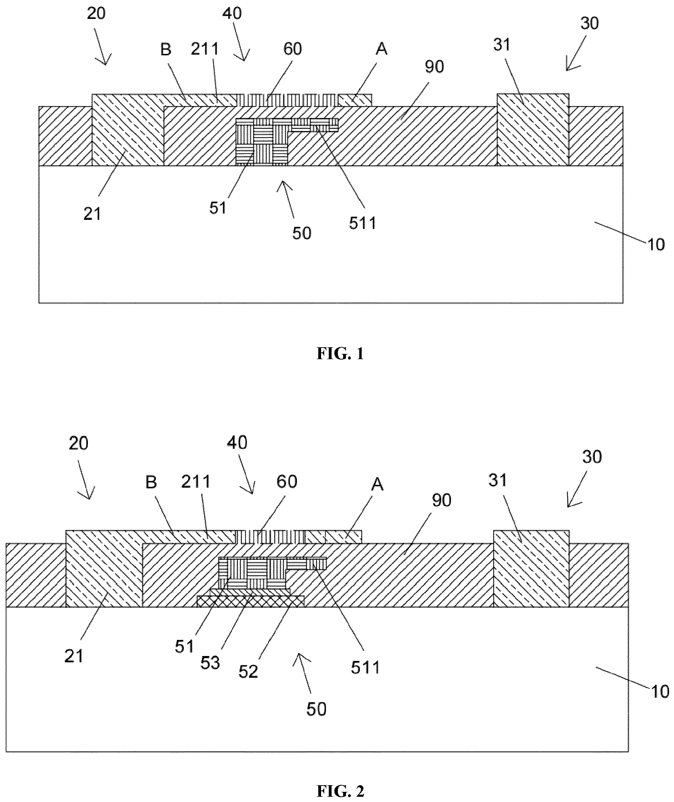

Depleted GaN-HEMT is used, as shown in FIG. 1. The source region 20 is formed in the GaN substrate 10 and includes a first source ohmic metal 21 in contact with a portion of the GaN substrate. The drain region 30 is formed in the GaN substrate 10 and is separated from the source region, and the drain region 30 includes a first drain ohmic metal 31 in contact with a portion of the GaN substrate. A gate stack 50 of the gate region 40 includes a gate metal 51 in contact with a portion of the GaN substrate 10, and a gate field plate 511 extending towards the drain region 30 is provided at one side of the gate metal.

A first source field plate 211 extending towards the drain region and across the gate field plate is provided at one side of the first source ohmic metal 21, and the first source field plate has a hollow structure region 60.

### Embodiment 2

A P-GaN enhanced GaN-HEMT is used, as shown in FIG. 2. Embodiment 2 is different from embodiment 1 in that the gate stack 50 includes a P-GaN layer 52 in contact with a portion of the GaN substrate, a Schottky metal 53 is formed on the P-GaN layer, and a gate metal 51 is formed on the Schottky metal.

### Embodiment 3

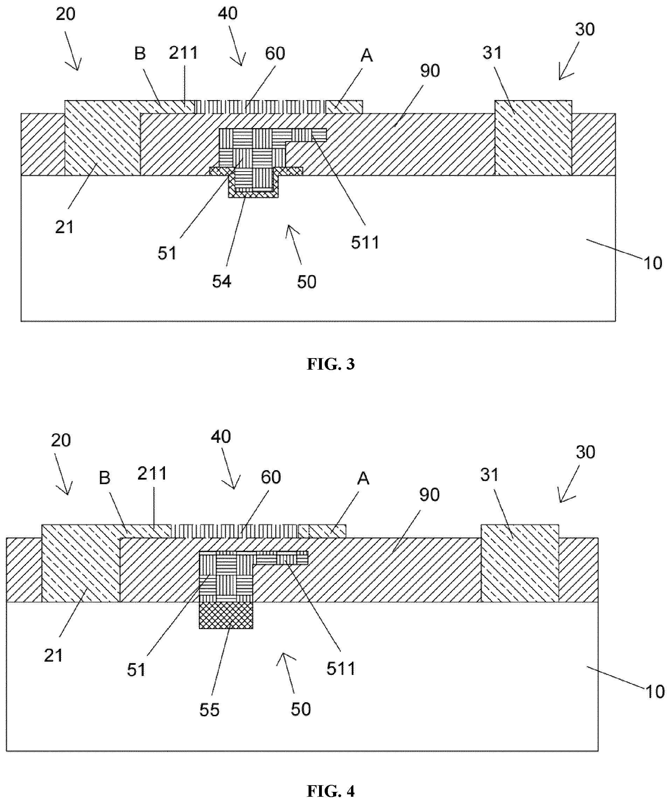

A recessed-gate enhanced GaN-HEMT is used, as shown in FIG. 3. Embodiment 2 is different from embodiment 1 in that the gate stack 50 includes a recessed gate 54 embedded in the GaN substrate and a gate metal 51 formed on the recessed gate.

### Embodiment 4

A fluoride-ion-implanted enhanced GaN-HEMT is used, as shown in FIG. 4. Embodiment 4 is different from embodiment 1 in that the gate stack 50 includes an ion implantation region 55 embedded in the GaN substrate 10 and a gate metal 51 formed on the ion implantation region.

### Embodiment 5

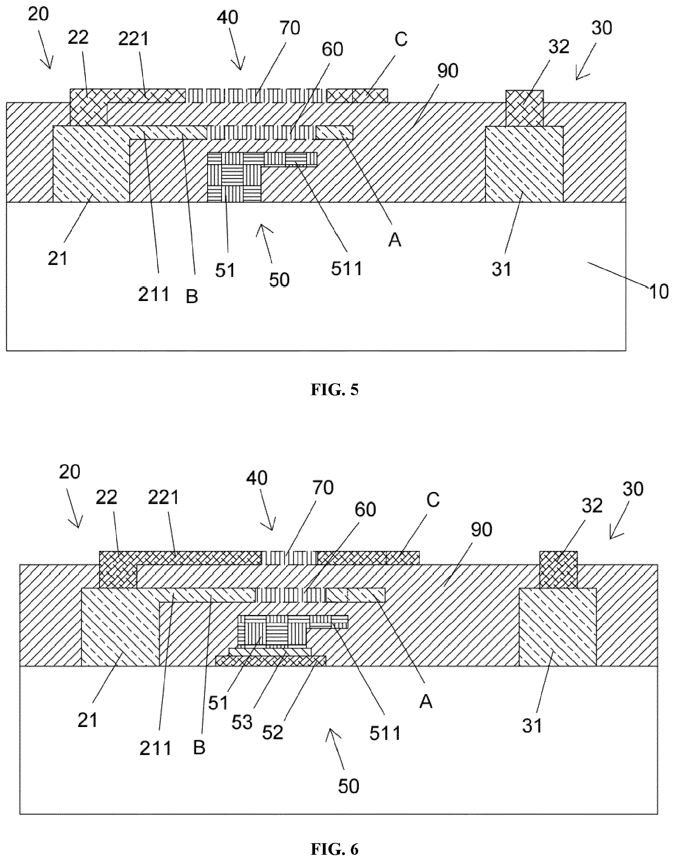

A depleted GaN-HEMT is used, as shown in FIG. 5. Embodiment 5 is different from embodiment 1 in that a second source metal 22 is further formed on the first source ohmic metal 21, a second source field plate 221 extending towards the drain region and across the first source field plate 211 is provided at one side of the second source metal, the second source field plate 221 has a hollow structure region 70, and the hollow structure region70 of the second source field plate overlaps at least in part with the hollow structure region 60 of the first source field plate in a longitudinal direction. The drain region 30 includes a first drain ohmic metal 31 in contact with a portion of the GaN substrate 10, and a second drain metal 32 is formed on the first drain ohmic metal.

### Embodiment 6

A P-GaN enhanced GaN-HEMT is used, as shown in FIG. 6. Embodiment 5 is different from embodiment 5 in that the gate stack 50 includes a P-GaN layer 52 in contact with a portion of the GaN substrate 10, a Schottky metal 53 is formed on the P-GaN layer, and a gate metal 51 is formed on the Schottky metal.

### Embodiment 7

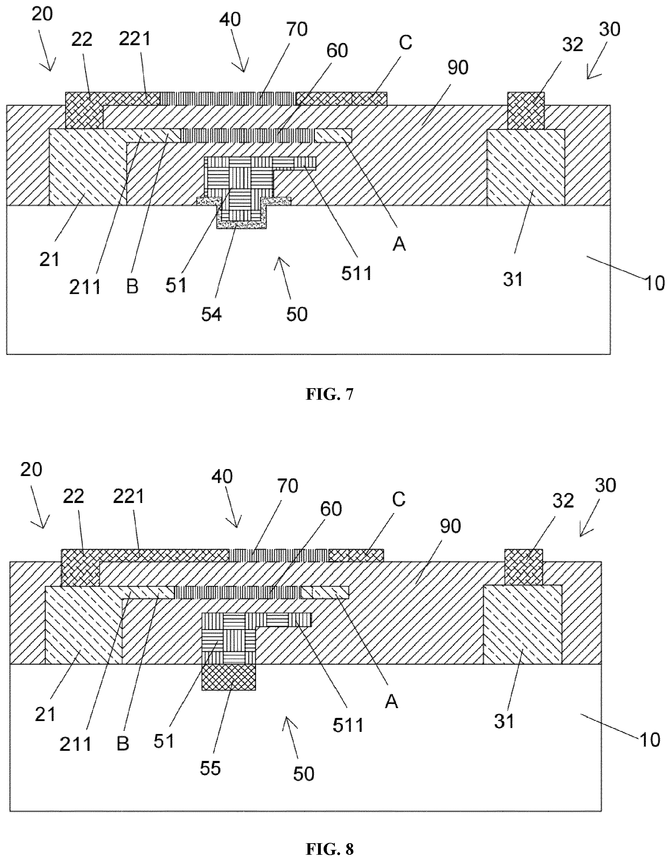

A recessed-gate enhanced GaN-HEMT is used, as shown in FIG. 7. Embodiment 5 is different from embodiment 5 in that the gate stack includes a recessed gate 54 embedded in the GaN substrate and a gate metal 51 formed on the recessed gate.

### Embodiment 8

A fluoride-ion-implanted enhanced GaN-HEMT is used, as shown in FIG. 8. Embodiment 5 is different from embodiment 5 in that the gate stack includes an ion implantation region 55 embedded in the GaN substrate and a gate metal 51 formed on the ion implantation region.

### Embodiment 9

A second source metal and a third source metal are stacked in sequence on the first source ohmic metal, a second source field plate extending towards the drain region and across the first source field plate is provided at one side of the second source metal, a third source field plate extending towards the drain region and across the second source field plate is provided at one side of the third source metal, the second source field plate and the third source field plate each have a hollow structure region, the hollow structure region of the third source field plate, the hollow structure region of the first source field plate and the hollow structure region of the second source field plate are overlapped at least in part, in a longitudinal direction. The third source field plate with a hollow structure has little effect on reducing the capacitance because the distance d to the third field plate is large. Of course, a fourth source metal is further formed on the third source metal, which makes the effect even weaker, but these structures are within the scope of protection of the present disclosure.

The hollow structure region 60 of the first source field plate 211 described in embodiments 1-4 covers at least a partial region of the gate region 40, and the hollow structure region 60 of the first source field plate is not formed at an edge A of the first source field plate 211 extending towards the drain region 30 beyond the gate field plate. In the embodiment 1, the hollow structure region 60 of the first source field plate completely overlaps with the gate region 40, and in the embodiment 2, the hollow structure region 60 of the first source field plate covers only a portion of the gate region 40.

The hollow structure region 60 of the first source field plate 211 is further formed at an edge B of the first source field plate extending towards the source region 20 beyond the gate field plate. In the embodiment 3, the hollow structure region 60 of the first source field plate 211 completely covers the gate region 40, and is distributed at the edge B of the first source field plate extending towards the source region beyond the gate field plate. In the embodiment 4, the hollow structure region 60 of the first source field plate 211 covers only a portion of the gate region 40, and is distributed at the edge B of the first source field plate extending towards the source region beyond the gate field plate.

The hollow structure region 70 of the second source field plate 221 described in embodiments 5-8 covers at least a partial region of the hollow structure 60 of the first source field plate, and the hollow structure region 70 of the second source field plate is not formed at an edge C of the second source field plate extending towards the drain region beyond the first source field plate 211.

In the embodiment 5, the hollow structure region 70 of the second source field plate 221 completely covers the hollow structure region 60 of the first source field plate. In the embodiment 6, the hollow structure region 70 of the second source field plate is completely covered by the hollow structure region 60 of the first source field plate. In the embodiment 7, the hollow structure region 70 of the second source field plate extends towards the source region 20 on the basis of the embodiment 6. In the embodiment 8, the hollow structure region 70 of the second source field plate extends towards the drain region 30 on the basis of the embodiment 6.

Preferably, overlapping portions of the first source field plate 211 and the second source field plate 221 with the grid field plate all are hollow structures.

The hollow structure region 60, 70 according to the present disclosure includes a plurality of longitudinal through-holes filled in the hollow structure region and perpendicular to surfaces of the field plates, and a non-hollow structure 83 acting as an electrical connection exists between longitudinal through-holes in each layer of the metal field plate. The longitudinal through-holes may be arranged in one, two or more rows, to form the hollow structure region.

Preferably, the longitudinal through-holes of the second source field plate and the longitudinal through-holes of the first source field plate are arranged concentrically from top to bottom, and the aperture of the longitudinal through-holes of the second source field plate is greater than or equal to the aperture of the longitudinal through-holes of the first source field plate. Such a design can avoid that the facing area is affected by the misalignment of the through-holes in two source field plates.

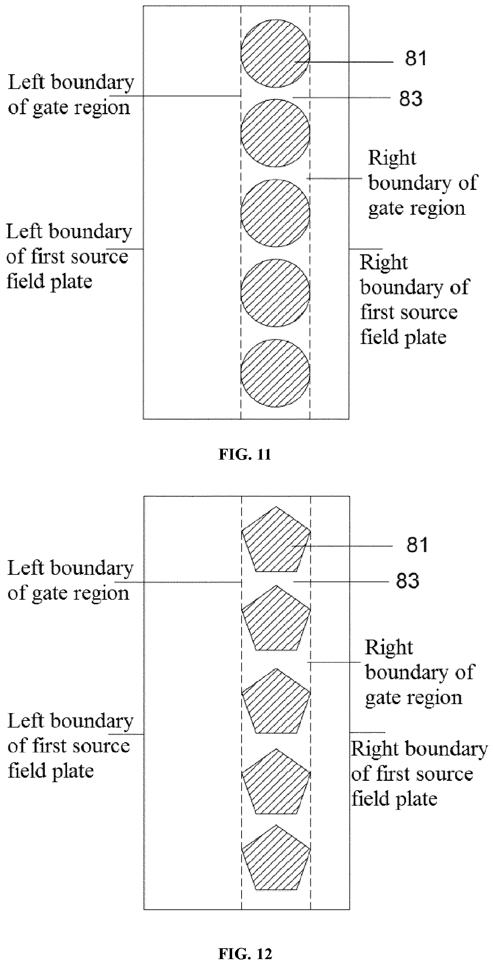

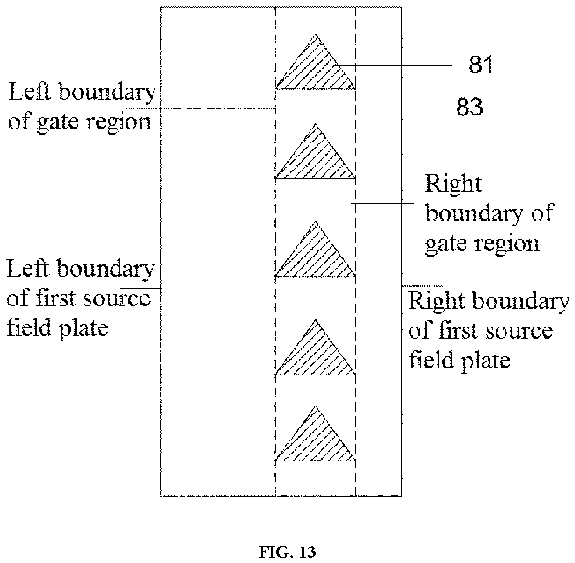

As shown in FIG. 10-13, the plurality of longitudinal through-holes 81 can be selected as any one of a rectangular hole, a circular hole, a pentagonal hole or a triangular hole. The specific shape of the longitudinal through-hole is not limited in the present disclosure, and any longitudinal through-hole capable of achieving the effect of reducing the facing area is within the protection scope of the present disclosure.

A specific measure is to achieve hollow design in an original field plate structure. Without changing an original product production process, and only by changing a pattern of a photoetching plate, the facing area between the gate field plate and the source field plate is reduced, thus reducing the parasitic capacitance between the gate and the source.

Further, the present disclosure includes the following technical solutions:
Solution 1. A gallium nitride (GaN) transistor for reducing input capacitance of a multilayer field board, comprising:
   a GaN substrate;
   a source region, formed in the GaN substrate and comprising a first source ohmic metal in contact with a portion of the GaN substrate;
   a drain region, formed in the GaN substrate and separated from the source region; and
   a gate region, formed in the GaN substrate and comprising a gate stack in contact with a portion of the GaN substrate, wherein the gate region is arranged between the source region and the drain region, and a gate field plate extending towards the drain region is provided at one side of a gate metal of the gate stack;
   wherein a first source field plate extending towards the drain region and across the gate field plate is provided at one side of the first source ohmic metal, and the first source field plate has a hollow structure region.
Solution 2. The GaN transistor according to solution 1, wherein a second source metal is further formed on the first source ohmic metal, a second source field plate extending towards the drain region and across the first source field plate is provided at one side of the second source metal, the second source field plate has a hollow structure region, and the hollow structure region of the second source field plate overlaps at least in part with the hollow structure region of the first source field plate in a longitudinal direction.
Solution 3. The GaN transistor according to any one of solutions 1 to 2, wherein a second source metal and a third source metal are stacked in sequence on the first source ohmic metal, a second source field plate extending towards the drain region and across the first source field plate is provided at one side of the second source metal, a third source field plate extending towards the drain region and across the second source field plate is provided at one side of the third source metal, the second source field plate and the third source field plate each have a hollow structure region, the hollow structure region of the third source field plate, the hollow structure region of the first source field plate and the hollow structure region of the second source field plate are overlapped at least in part, in a longitudinal direction.
Solution 4. The GaN transistor according to any one of solutions 1 to 3, wherein the hollow structure region of the first source field plate covers at least a partial region of the gate region, and the hollow structure region of the first source field plate is not formed at an edge of the first source field plate extending towards the drain region beyond the gate field plate.
Solution 5. The GaN transistor according to any one of solutions 1 to 4, wherein the hollow structure region of the second source field plate covers at least a partial region of the hollow structure of the first source field plate, and the hollow structure region of the second source field plate is not formed at an edge of the second source field plate extending towards the drain region beyond the first source field plate.
Solution 6. The GaN transistor according to any one of solutions 1 to 5, wherein the hollow structure region of the first source field plate is further formed at an edge of the first source field plate extending towards the source region beyond the gate field plate.
Solution 7. The GaN transistor according to any one of solutions 1 to 6, wherein the hollow structure region of the second source field plate is further formed at an edge of the second source field plate extending towards the source region beyond the gate field plate.
Solution 8. The GaN transistor according to any one of solutions 1 to 7, wherein an overlapping portion of the first source field plate with the gate region is the hollow structure region.
Solution 9. The GaN transistor according to any one of solutions 1 to 8, wherein an overlapping portion of the second source field plate with the first source field plate is the hollow structure region.
Solution 10. The GaN transistor according to any one of solutions 1 to 9, wherein the hollow structure region comprises a plurality of longitudinal through-holes filled in the hollow structure region and perpendicular to surfaces of the field plates.
Solution 11. The GaN transistor according to any one of solutions 1 to 10, wherein the hollow structure region comprises a plurality of longitudinal through-holes filled in the hollow structure region and perpendicular to surfaces of the field plates.
Solution 12. The GaN transistor according to any one of solutions 1 to 11, wherein the longitudinal through-holes of the second source field plate and the longitudinal through-holes of the first source field plate are arranged concentrically from top to bottom, and the aperture of the longitudinal through-holes of the second source field plate is greater than or equal to the aperture of the longitudinal through-holes of the first source field plate.
Solution 13. The GaN transistor according to any one of solutions 1 to 12, wherein the plurality of longitudinal through-holes are any one of rectangular holes, circular holes, pentagonal holes and triangular holes.
Solution 14. The GaN transistor according to any one of solutions 1 to 13, wherein the plurality of longitudinal through-holes are any one of rectangular holes, circular holes, pentagonal holes, and triangular holes.
Solution 15. The GaN transistor according to any one of solutions 1 to 14, wherein the gate metal of the gate stack is in contact with a portion of the GaN substrate.
Solution 16. The GaN transistor according to any one of solutions 1 to 15, wherein the gate stack comprises a P-GaN layer in contact with a portion of the GaN substrate, a Schottky metal is formed on the P-GaN layer, and the gate metal is formed on the Schottky metal.
Solution 17. The GaN transistor according to any one of solutions 1 to 16, wherein the gate stack comprises a recessed gate embedded in the GaN substrate and a gate metal formed on the recessed gate.
Solution 18. The GaN transistor according to any one of solutions 1 to 17, wherein the gate stack comprises an ion implantation region embedded in the GaN substrate and a gate metal formed on the ion implantation region.
Solution 19. The GaN transistor according to any one of solutions 1 to 18, wherein the GaN substrate comprises a substrate, a nucleation layer, a buffer layer, a first GaN layer, a second GaN layer, and an AlGaN barrier layer stacked in sequence.
Solution 20. The GaN transistor according to any one of solutions 1 to 19, wherein the GaN substrate comprises a substrate, a nucleation layer, a buffer layer, a first insertion layer, a first GaN layer, a second insertion layer, a second GaN layer and an AlGaN barrier layer stacked in sequence.
Solution 21. The GaN transistor according to any one of solutions 1 to 20, wherein the drain region comprises a first drain ohmic metal in contact with a portion of the GaN substrate, and a second drain metal is formed on the first drain ohmic metal.

The above implementation is only a description of a preferred implementation of the present disclosure, and is not intended to limit the scope of the present disclosure. Without departing from the spirit of the design of the present disclosure, various modifications and improvements made by a person of ordinary skill in the art to the technical solutions of the present disclosure shall fall into the protection scope defined in the claims of the present disclosure.

## Claims

1. A gallium nitride (GaN) transistor for reducing input capacitance of a multilayer field board, comprising:
a GaN substrate;
a source region, formed in the GaN substrate and comprising a first source ohmic metal in contact with a portion of the GaN substrate;
a drain region, formed in the GaN substrate and separated from the source region; and
a gate region, formed in the GaN substrate and comprising a gate stack in contact with a portion of the GaN substrate, wherein the gate region is arranged between the source region and the drain region, and a gate field plate extending towards the drain region is provided at one side of a gate metal of the gate stack;
wherein a first source field plate extending towards the drain region and across the gate field plate is provided at one side of the first source ohmic metal, and the first source field plate has a hollow structure region.

2. The GaN transistor according to claim 1, wherein a second source metal is further formed on the first source ohmic metal, a second source field plate extending towards the drain region and across the first source field plate is provided at one side of the second source metal, the second source field plate has a hollow structure region, and the hollow structure region of the second source field plate overlaps at least in part with the hollow structure region of the first source field plate in a longitudinal direction.

3. The GaN transistor according to claim 1, wherein a second source metal and a third source metal are stacked in sequence on the first source ohmic metal, a second source field plate extending towards the drain region and across the first source field plate is provided at one side of the second source metal, a third source field plate extending towards the drain region and across the second source field plate is provided at one side of the third source metal, the second source field plate and the third source field plate each have a hollow structure region, the hollow structure region of the third source field plate, the hollow structure region of the first source field plate and the hollow structure region of the second source field plate are overlapped at least in part, in a longitudinal direction.

4. The GaN transistor according to claim 1, wherein the hollow structure region of the first source field plate covers at least a partial region of the gate region, and the hollow structure region of the first source field plate is not formed at an edge of the first source field plate extending towards the drain region beyond the gate field plate.

5. The GaN transistor according to claim 2, wherein the hollow structure region of the second source field plate covers at least a partial region of the hollow structure of the first source field plate, and the hollow structure region of the second source field plate is not formed at an edge of the second source field plate extending towards the drain region beyond the first source field plate.

6. The GaN transistor according to claim 4, wherein the hollow structure region of the first source field plate is further formed at an edge of the first source field plate extending towards the source region beyond the gate field plate.

7. The GaN transistor according to claim 5, wherein the hollow structure region of the second source field plate is further formed at an edge of the second source field plate extending towards the source region beyond the gate field plate.

8. The GaN transistor according to claim 1, wherein an overlapping portion of the first source field plate with the gate region is the hollow structure region.

9. The GaN transistor according to claim 2, wherein an overlapping portion of the second source field plate with the first source field plate is the hollow structure region.

10. The GaN transistor according to any one of claims 1, 4, 6 or 8, wherein the hollow structure region comprises a plurality of longitudinal through-holes filled in the hollow structure region and perpendicular to surfaces of the field plates.

11. The GaN transistor according to any one of claims 2, 5, 7 or 9, wherein the hollow structure region comprises a plurality of longitudinal through-holes filled in the hollow structure region and perpendicular to surfaces of the field plates.

12. The GaN transistor according to claim 11, wherein the longitudinal through-holes of the second source field plate and the longitudinal through-holes of the first source field plate are arranged concentrically from top to bottom, and the aperture of the longitudinal through-holes of the second source field plate is greater than or equal to the aperture of the longitudinal through-holes of the first source field plate.

13. The GaN transistor according to claim 10, wherein the plurality of longitudinal through-holes are any one of rectangular holes, circular holes, pentagonal holes and triangular holes.

14. The GaN transistor according to claim 11, wherein the plurality of longitudinal through-holes are any one of rectangular holes, circular holes, pentagonal holes, and triangular holes.

15. The GaN transistor according to claims 1 or 2, wherein the gate metal of the gate stack is in contact with a portion of the GaN substrate.

16. The GaN transistor according to claims 1 or 2, wherein the gate stack comprises a P-GaN layer in contact with a portion of the GaN substrate, a Schottky metal is formed on the P-GaN layer, and the gate metal is formed on the Schottky metal.

17. The GaN transistor according to claims 1 or 2, wherein the gate stack comprises a recessed gate embedded in the GaN substrate and a gate metal formed on the recessed gate.

18. The GaN transistor according to claims 1 or 2, wherein the gate stack comprises an ion implantation region embedded in the GaN substrate and a gate metal formed on the ion implantation region.

19. The GaN transistor according to claims 1 or 2, wherein the GaN substrate comprises a substrate, a nucleation layer, a buffer layer, a first GaN layer, a second GaN layer, and an AlGaN barrier layer stacked in sequence.

20. The GaN transistor according to claims 1 or 2, wherein the GaN substrate comprises a substrate, a nucleation layer, a buffer layer, a first insertion layer, a first GaN layer, a second insertion layer, a second GaN layer and an AlGaN barrier layer stacked in sequence.

21. The GaN transistor according to claim 2, wherein the drain region comprises a first drain ohmic metal in contact with a portion of the GaN substrate, and a second drain metal is formed on the first drain ohmic metal.
